# EUROPÄISCHE PATENTSCHRIFT

(11) **EP 0 274 075 B1**
(45) Veröffentlichungstag und Bekanntmachung des Hinweises auf die Patenterteilung: **26.05.1993**
(21) Anmeldenummer: 87118277.0
(22) Anmeldetag: 10.12.1987
(51) Int. Cl.: C08F 8/28, G03C 1/00, G03F 7/00

(54) **Polyvinylacetal, dieses enthaltendes lichtempfindliches Gemisch und daraus hergestelltes Aufzeichnungsmaterial**
Polyvinyl acetal, light-sensitive composition containing it and reproduction material made therefrom
Acétal polyvinylique, composition photosensible et matériau de reproduction préparé avec ladite composition

(30) Priorität: 23.12.1986 DE 3644162
(43) Veröffentlichungstag der Anmeldung: 13.07.1988
(73) Patentinhaber: HOECHST AKTIENGESELLSCHAFT, 65926 Frankfurt am Main (DE)
(72) Erfinder: Pawlowski, Georg, Dr., D-6200 Wiesbaden (DE)

(56) Entgegenhaltungen:
- EP-A- 0 216 083
- DE-A- 2 438 954
- DE-C- 888 008
- DE-C- 906 754
- FR-A- 2 152 884
- GB-A- 873 263

## Beschreibung

Die Erfindung betrifft ein neues Polyvinylacetal, das insbesondere als Bindemittel für lichtempfindliche Gemische in Aufzeichnungsmaterialien geeignet ist, die zur Herstellung von Druckplatten und Photoresists dienen.

Lichtempfindliche Gemische, die als Bindemittel Polyvinylacetale, z. B. Polyvinylformale oder Polyvinylbutyrale, und als lichtempfindliche Verbindungen Diazoniumsalz-Polykondensationsprodukte enthalten, sind aus der US-A 3 867 147 bekannt. Sofern diese Bindemittel in ausreichendem Mengenanteil enthalten sind und eine ausreichende Oleophilie aufweisen, werden damit Flachdruckplatten mit hoher Auflagenleistung erhalten. Diese lichtempfindlichen Druckplatten erfordern zu ihrer Entwicklung wäßrige Lösungen, die mehr oder weniger große Mengen an organischen Lösemitteln enthalten. Da sowohl Dämpfe als auch Abwässer aus diesen Entwicklern aus ökologischen Gründen nicht mehr akzeptiert werden, ist man bestrebt, auch die Entwicklung von Druckplatten dieses Typs mit rein wäßrigen Lösungen zu erreichen. Im günstigsten Fall können solche Platten mit relativ aggressiven sauren oder alkalischen rein wäßrigen Lösungen entwickelt werden, indem die Nichtbildbereiche der Schicht in Form von Fladen oder kleineren Partikeln im Entwickler suspendiert werden. Dabei besteht die Gefahr, daß sich solche Partikel unkontrolliert an Nichtbildstellen der Platte redeponieren und diese unbrauchbar machen.

Aus der DE-A 30 36 077 ist es bekannt, lichtempfindliche Gemische aus Mischkondensationsprodukten von kondensationsfähigen Diazoniumsalzen und anderen nicht lichtempfindlichen kondensationsfähigen Verbindungen, in Kombination mit polymeren Bindemitteln, die seitenständige Alkenylsulfonylurethangruppen enthalten, zur Herstellung von Druckplatten zu verwenden. Diese Gemische lassen sich mit rein wäßrigen, alkalischen Lösungen entwickeln. Bei der Verarbeitung zu Flachdruckplatten ergeben sie jedoch lichtgehärtete Schichten, deren Farbannahme nicht zufriedenstellend ist.

Aus der EP-A 152 819 sind lichtempfindliche Gemische aus Diazoniumsalz-Polykondensationsprodukten und Carboxylgruppen enthaltenden Bindemitteln bekannt, die durch Umsetzen von Hydroxylgruppen enthaltenden Polymeren mit Säureanhydriden erhalten worden sind. Diese Gemische lassen sich mit wäßrig-alkalischen Lösungen entwickeln und sind zur Herstellung von Flachdruckformen hoher Auflagenleistung geeignet. Diese Gemische haben, ebenso wie andere Gemische mit Carboxylgruppen enthaltenden Bindemitteln, den Nachteil, daß sie bei der Verarbeitung mit Entwicklern auf Basis von Leitungswasser zur Ausfällung schwerlöslicher Calciumsalze neigen, die sich in den Entwicklungsmaschinen absetzen und zu Störungen führen.

In der DE-C 888 008 werden Polyvinylacetale beschrieben, die Einheiten enthalten, die von einfachen aliphatischen Aldehyden abgeleitet sind, sowie solche, die von aromatischen Hydroxyaldehyden, z. B. Salicylaldehyd, abgeleitet sind. Die erhaltenen Polymeren sind licht- und wärmestabil und als Zwischenschicht für Sicherheitsglas geeignet.

In den nicht vorveröffentlichten EP-A 216 083 und 211 406 werden bestimmte Polyvinylacetale und daraus hergestellte lichtempfindliche Gemische beschrieben, die sich mit rein wäßrigen Entwicklern entwickeln lassen. Die Polymeren enthalten bestimmte Mengenanteile an 1,2-Vinylacetaleinheiten, 1,3-Vinylacetaleinheiten und intermolekularen Acetalgruppen.

Aufgabe der Erfindung war es, neue Polyvinylacetale und diese enthaltende lichtempfindliche Gemische vorzuschlagen, die sich mit rein wäßrigen neutralen oder schwach alkalischen Lösungen entwickeln lassen, die Bildbereiche mit guter Oleophilie, Abriebbeständigkeit beim Druck und Ätzfestigkeit ergeben, aber bei der Verarbeitung mit Leitungswasser enthaltenden Entwicklerlösungen keine störenden Abscheidungen ergeben.

Erfindungsgemäß wird ein Polymeres der allgemeinen Formel I 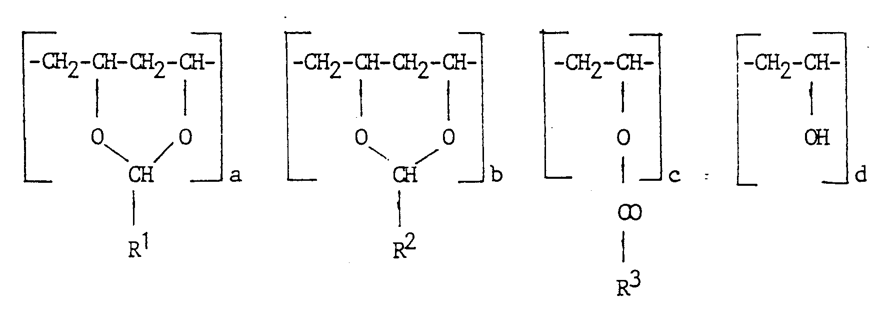
vorgeschlagen, worin
R¹ einer der Reste 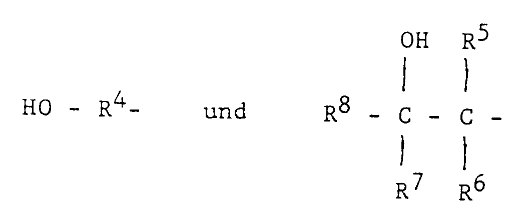
R² ein Wasserstoffatom, ein Alkylrest mit 1 bis 6 Kohlenstoffatomen, der gegebenenfalls durch Halogenatome, Aryl-, Aryloxy- oder Alkoxygruppen substituiert ist, oder ein Arylrest, der gegebenenfalls durch Halogenatome, Alkyl-, Alkoxy- oder Carbonsäureesterreste substituiert ist,
R³ ein Alkylrest mit 1 bis 4 Kohlenstoffatomen,
R⁴ eine substituierte oder unsubstituierte Alkylengruppe mit 1 bis 6 Kohlenstoffatomen ist,
R⁵ ein Wasserstoffatom, ein Alkylrest mit 1 bis 6 Kohlenstoffatomen, ein Alkoxyrest mit 1 bis 4 Kohlenstoffatomen oder ein Hydroxyalkylrest mit 1 bis 3 Kohlenstoffatomen,
R⁶ ein Rest der bei R⁵ angegebenen Bedeutung oder eine Hydroxygruppe,
R⁷ ein Wasserstoffatom oder ein Alkylrest mit 1 bis 6 Kohlenstoffatomen
R⁸ ein Wasserstoffatom, ein Alkyl-, Hydroxyalkyl- oder Alkoxyalkylrest mit 1 bis 6 Kohlenstoffatomen oder ein substituierter oder unsubstituierter Arylrest mit 6 bis 10 Kohlenstoffatomen,

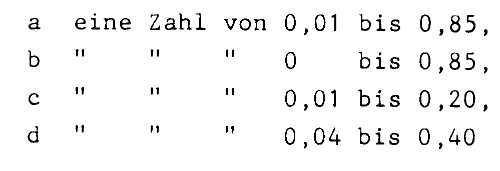

und die Summe a + b + c + d = 1 ist.

Erfindungsgemäß wird ferner ein lichtempfindliches Gemisch vorgeschlagen, das als wesentliche Bestandteile eine lichthärtbare Substanz und ein Polyvinylacetal enthält.

Das erfindungsgemäße Gemisch ist dadurch gekennzeichnet, daß das Polyvinylacetal eine Verbindung der allgemeinen Formel I entsprechend der vorstehenden Definition ist.

Erfindungsgemäß wird schließlich auch ein lichtempfindliches Aufzeichnungsmaterial mit einem Schichtträger und einer lichtempfindlichen Schicht vorgeschlagen, das dadurch gekennzeichnet ist, daß die lichtempfindliche Schicht aus einem lichtempfindlichen Gemisch entsprechend der vorstehenden Definition besteht.

Die erfindungsgemäßen Polymeren der Formel I enthalten mindestens drei, bevorzugt vier verschiedene Typen von Einheiten in den oben angegebenen Molverhältnissen. Dabei ist vorzugsweise a eine Zahl von mindestens 0,05, b eine Zahl von 0,2 bis 0,6, c eine Zahl von 0,01 bis 0,15 und d eine Zahl von 0,04 bis 0,2, wobei die Summe a+b+c+d=1 ist. Mit höheren Werten von a und d nimmt die Hydrophilie der Polymeren zu. Gleichzeitig bleibt aber, insbesondere bei höheren Werten von a, auch bei relativ hohen Hydroxylzahlen die Löslichkeit in organischen Lösemitteln erhalten.

In den Verbindungen der Formel I haben die Symbole bevorzugt die folgende Bedeutung:

Wenn R² ein Alkylrest ist, kann dieser als Substituenten vorzugsweise Halogenatome, Aryl-, Aryloxy-oder Alkoxygruppen enthalten. Der Alkylrest R² selbst hat bevorzugt 1 bis 4 Kohlenstoffatome, seine aromatischen Substituenten haben 6 bis 8 und seine aliphatischen Substituenten 1 bis 3 Kohlenstoffatome.

Wenn R² ein Arylrest ist, kann er als Substituenten insbesondere Halogenatome, Alkyl-, Alkoxy- oder Carbonsäureesterreste enthalten.

Als Arylreste werden allgemein einkernige Arylreste bevorzugt, die einschließlich Substituenten bis zu 10 Kohlenstoffatome enthalten können.
- R³: ist bevorzugt ein Methylrest.
- R⁴: kann als Substituenten insbesondere Halogenatome oder Alkoxygruppen enthalten und hat insgesamt 1 bis 6, bevorzugt 2 bis 5 Kohlenstoffatome.
- R⁵ und R⁶: sind vorzugsweise Wasserstoffatome, Alkylreste mit 1 bis 4 Kohlenstoffatomen oder Hydroxymethylreste.
- R⁷: ist bevorzugt ein Wasserstoffatom.
- R⁸: ist bevorzugt ein Wasserstoffatom oder ein Alkylrest mit 1 bis 4 Kohlenstoffatomen, ein Hydroxyalkyl- oder Alkoxyalkylrest mit 1 bis 4 Kohlenstoffatomen.

Der Rest R¹ enthält mindestens eine und bis zu drei, vorzugsweise bis zu 2 Hydroxygruppen.

Die erfindungsgemäßen Polymeren haben bevorzugt mittlere Molekulargewichte von 5.000 bis 250.000 und Hydroxylzahlen von 150 bis 600.

Als Ausgangsstoffe für die Herstellung der erfindungsgemäßen Polymeren werden im allgemeinen Vinylacetat-Vinylalkohol-Copolymere mit mindestens 80 % Vinylalkoholeinheiten und mittleren Molekulargewichten von 3.000 bis 150.000 oder darüber, bevorzugt von 20.000 bis 100.000 eingesetzt. Solche Copolymeren lassen sich einfach herstellen oder sind handelsüblich. Von den handelsüblichen Polyvinylalkoholen werden solche mit 88-98 % Verseifungsgrad und K-Werten von 4 bis 20 bevorzugt.

Sollen die erfindungsgemäßen Polymeren in lichtempfindlichen Schichten für Flachdruckformen eingesetzt werden, so werden solche hydroxylgruppenhaltigen Ausgangspolymeren bevorzugt, die ein Molekulargewicht zwischen 20.000 und 100.000 oder darüber, und einen Vinylacetatgehalt von weniger als 15 % aufweisen. Beim Einsatz der lichtempfindlichen Schichten als Siebdruckschablonen oder in der Resisttechnik zur Herstellung von Ätzreservagen und dergleichen eignen sich besonders solche Ausgangspolymeren, die Molekulargewichte unterhalb 50.000 aufweisen und einen Vinylacetatanteil von mehr als 5 % haben.

Zur Herstellung von Vinylacetaleinheiten mit einem Rest R¹ werden Aldehyde der allgemeinen Formeln II und III verwendet, worin R⁴ bis R⁸ die vorstehend beschriebenen Bedeutungen haben: 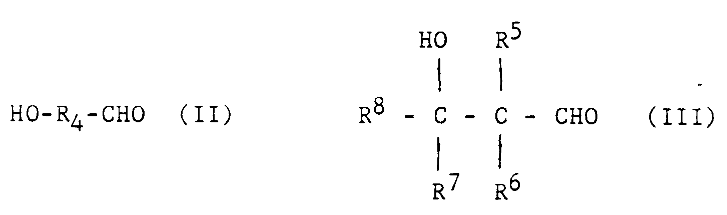
Derartige Aldehyde sind teils handelsüblich, teils lassen sie sich nach bekannten Methoden auf einfachem Wege herstellen. Eine umfassende Beschreibung der Synthesemöglichkeiten von Aldehyden der Formel III ist in Organic Reactions, Volume 16, Seiten 80 und 86 bis 102 angegeben. Darüber hinaus gibt es zahlreiche weitere Synthesemethoden für die Aldehyde der allgemeinen Formeln II und III, die z. T. in Houben-Weyl, Bde. 4/1a, S. 375 ff, 4/1d, S. 348 ff. 6/1a, S. 452 ff, 7/1, S. 89 und 170 ff, sowie E 3, S. 212 ff, 348 ff, 439 ff, 474 ff oder 659 ff referiert werden.

Zur Herstellung von Copolymereinheiten mit einem Rest R² werden Aldehyde der allgemeinen Formel IV verwendet, worin R² die vorstehend angegebene Bedeutung aufweist:

R² - CHO (IV)

Derartige Aldehyde sind ebenfalls zumeist handelsüblich oder lassen sich durch bekannte Methoden herstellen. Einige Herstellungsbeispiele für geeignete Aldehyde werden in den Ausführungsbeispielen beschrieben.

Beispiele für geeignete Aldehyde der allgemeinen Formeln II und III sind:
2-Hydroxyethanal,
3-Hydroxypropanal,
2,3-Dihydroxypropanal,
2-Methyl-3-hydroxypropanal,
2,2-Dimethyl-3-hydroxypropanal,
2-Methyl-2-methylolpropanal,
2-Hydroxybutanal,
3-Hydroxybutanal,
4-Hydroxybutanal,
3-Hydroxy-2-methylbutanal,
3-Hydroxy-2-ethylbutanal,
2-Methyl-2-methylolbutanal,
2,2-Dimethyl-3-hydroxybutanal,
2,2-Dimethylolbutanal,
2,2-Dimethylol-3-hydroxybutanal,
2-Hydroxypentanal,
3-Hydroxypentanal,
3-Hydroxy-2-methylpentanal,
2,2-Dimethyl-3-hydroxypentanal,
2-Ethyl-3-hydroxypentanal,
2-Methylolpentanal,
5-Hydroxypentanal,
3-Hydroxyhexanal,
3-Hydroxy-2-methylhexanal,
2-Ethyl-3-hydroxyhexanal,
3-Hydroxy-2-methoxy-5-oxa-hexanal,
2,2-Diethyl-3-hydroxyhexanal,
3-Hydroxy-2,2,5-trimethylhexanal,
2-Ethyl-2,4-dimethyl-3-hydroxy-hexanal,
3-Hydroxy-2-isopropyl-5-methylhexanal,
2,2-Dimethylolhexanal,
2,2-Dimethyl-3-hydroxyheptanal,
2-Methyl-2-methylolheptanal,
2,2-Dimethylolheptanal und
2-Butyl-3-hydroxyoctanal.

Unter diesen Aldehyden werden die Selbstkondensationsprodukte des Acetaldehyds und seiner höheren Homologen, sowie die Kondensationsprodukte von Acetaldehyd mit Propionaldehyd oder höheren aliphatischen Aldehyden sowie 4-Hydroxybutanal und 5-Hydroxypentanal bevorzugt.

Beispiele für geeignete Aldehyde der Formel IV sind:
Formaldehyd, Acetaldehyd, Propanal, n-Butanal, Isobutanal, Pentanal, Benzaldehyd, 2-, 3- oder 4-Methylbenzaldehyd, 2-, 3- oder 4-Methoxybenzaldehyd, 2-, 3- oder 4-Chlorbenzaldehyd, 4-Formylbenzoesäureethylester und, weniger bevorzugt, 4-Carboxybenzaldehyd.

Anstelle der freien Aldehyde können auch die entsprechenden Acetale mit niederen Alkoholen, z. B. 2-Methoxy-acetaldehyddimethylacetal, Brom- oder Chloracetaldehyddiethylacetal oder die Umsetzungsprodukte von Phenolen mit Halogenalkyldialkylacetalen, eingesetzt werden. Die Acetale können unmittelbar oder nach Hydrolyse zum Aldehyd mit dem Polymeren umgesetzt werden.

Bevorzugte Aldehyde der Formel IV sind Formaldehyd, Acetaldehyd, Propanal, n-Butanal, Isobutanal, Benzaldehyd; p-Chlorbenzaldehyd, 3- und 4-Methoxybenzaldehyd.

Die Herstellung der erfindungsgemäßen Polyvinylacetale kann nach zwei Verfahren erfolgen:
Bei der ersten Ausführungsform wird ein geeignetes Vinylalkohol/Vinylacetat-Copolymeres, das mindestens 80 mol-% Vinylalkoholeinheiten aufweist, in einem Alkohol dispergiert, mit einer katalytischen Menge einer anorganischen oder starken organischen Säure und einem Aldehyd oder einem Aldehydgemisch in solcher Menge versetzt, daß vorzugsweise mindestens 50 % der Hydroxylgruppen acetalisiert werden, und erwärmt. Die erhaltene Polymerlösung, der gegebenenfalls ein Antioxidationsmittel einverleibt worden ist, kann direkt in die erfindungsgemäßen Gemische eingearbeitet werden, oder das Polymere kann durch Eintropfen in einen Nichtlöser ausgefällt und gereinigt werden.

Bei der zweiten Ausführungsform wird das Vinylalkohol/Vinylacetat-Copolymere in einer wäßrigen oder wäßrigalkoholischen Lösung gelöst und mit dem Aldehyd oder dem Aldehydgemisch versetzt. Dann wird bei Raumtemperatur eine wäßrige Mischung einer anorganischen oder starken organischen Säure, gegebenenfalls unter Zusatz eines Netzmittels oder eines Antioxidationsmittels, zugetropft. Dabei fällt das Polyvinylacetal aus; durch Erhitzen der Mischung auf Temperaturen zwischen 30 und 60° C wird die Reaktion vervollständigt, und das isolierte Polymere wird durch Waschen mit Wasser oder Lösen und Wiederausfällen gereinigt.

Die erste Ausführungsform wird besonders dann bevorzugt, wenn das erfindungsgemäße Polymere eine Hydroxyzahl von mehr als 450 mg KOH pro g Polymer aufweisen soll. Diese Polymeren lösen sich in wäßrigen, tensidhaltigen Lösungen. Darüber hinaus ist dieses Verfahren auch dann geeignet, wenn Aldehyde unterschiedlicher Reaktivität oder in wäßrigen Lösungen unlösliche, bei Raumtemperatur feste Aldehyde eingesetzt werden.

Zu diesem Zweck wird das Vinylacetat/Vinylalkohol-Copolymere in einem Alkohol, bevorzugt Ethanol, dispergiert. Gegebenenfalls kann dem Alkohol eine geringe Menge Wasser zugefügt sein, so daß das Polymere in der Mischung angelöst wird. Das Verhältnis von Lösungsmittel bzw. Lösungsmittelgemisch zu Polymer beträgt vorzugsweise 10 : 1 bis 100 : 1. Das Gemisch wird sehr intensiv gerührt.

Die Menge der zugesetzten Säure beträgt bevorzugt 1 bis 25 Gew.-%, bezogen auf das Polymere. Als Säuren kommen insbesondere Chlorwasserstoffsäure oder Schwefelsäure in Betracht; Phosphorsäure oder Toluolsulfonsäure lassen sich ebenfalls verwenden, sind aber weniger bevorzugt. Dann wird der Aldehyd oder das Aldehydgemisch auf einmal zugegeben und die Mischung solange auf 60 - 150° C erhitzt, bis der gesamte Polyvinylalkohol in Lösung gegangen ist. Ab diesem Zeitpunkt wird die Mischung noch 2 bis 20 Stunden, bevorzugt 2 - 6 Stunden, bei Temperaturen zwischen 50 und 150° C nachgerührt. Die Menge des zugesetzten Aldehyds richtet sich nach den Erfordernissen, i. a. werden pro mol Vinylalkohol etwa 0,1 bis 2,0, bevorzugt 0,25 bis 1,5 mol Aldehyd zugegeben. Die klare Lösung kann je nach Bedarf direkt eingesetzt werden, sofern die anwesende Säure keinen nachteiligen Einfluß auf das lichtempfindliche Gemisch hat. Darüber hinaus enthält die Lösung wechselnde Anteile an niedermolekularen Acetalen, die durch Acetalisierung des Aldehyds mit dem Lösemittel gebildet werden. Es ist daher häufig günstiger, das Polymere durch Eingießen in einen Nichtlöser auszufällen und anschließend zu trocknen, wodurch sich die Säure abtrennen läßt und die monomeren Acetale entfernt werden. Als Nichtlöser eignet sich häufig Wasser, dem gegebenenfalls eine größere Menge eines anorganischen Salzes zugefügt worden ist, um eine Aussalzung des erfindungsgemäßen Polymeren zu erzielen.

Das zweite Verfahren führt zu einheitlicheren Produkten und findet insbesondere dann Anwendung, wenn das erfindungsgemäße Polymere eine Hydroxylzahl zwischen 150 und 450 aufweisen soll. In diesem Fall wird eine 3 bis 20%ige Lösung des Polyvinylalkohols in Wasser bereitet. Zu dieser Lösung wird bei Raumtemperatur und unter starkem Rühren der Aldehyd bzw. das Aldehydgemisch gegeben, das in diesem Fall bevorzugt flüssig sein sollte. Dieser gut gerührten Dispersion wird gegebenenfalls ein Antioxydans (z. B. 2,6-Di-t-butyl-kresol) zugefügt und dann die Säure, bevorzugt als 5 - 25 %ige wäßrige Lösung zugetropft. Der wäßrigen Säure kann gegebenenfalls ein Tensid, dessen Art für den jeweils gewünschten Anwendungszweck neu bestimmt werden sollte, beigefügt sein. Nach einiger Zeit fällt das polymere Umsetzungsprodukt, bei optimierten Bedingungen im allgemeinen als grob- oder feinkörniges, gelegentlich verklebendes Pulver, aus. Das Gemisch wird 1 bis 5 Stunden nachgerührt und dann mit weiterer Säure versetzt, wobei pro mol Aldehyd etwa 0,05 bis 0,5 mol Säure günstig wirken. Das Gemisch wird auf 35 bis 85°C erwärmt und weitere 2 bis 6 Stunden gerührt. Danach wird das Polymere abfiltriert, reichlich mit Wasser gewaschen und getrocknet. Bevorzugt wird dann das Polymere in einem organischen Lösemittel, beispielsweise einem Alkohol, gelöst und dann erneut in einer großen Menge eines Nichtlösers, bevorzugt Wasser, ausgefällt. Die beim zweiten Herstellungsverfahren angewendeten stöchiometrischen Verhältnisse entsprechen, soweit nicht anders angegeben, denen des ersten Herstellungsverfahrens.

Die erfindungsgemäß hergestellten Polymeren fallen, insbesondere nach Ausfällen in einem Nichtlöser, als amorphe, farblose Produkte an, die sich jedoch leicht abtrennen lassen. Es hat sich als günstig erwiesen, wenn die Produkte vor ihrer Verwendung in lichtempfindlichen Schichten ausreichend getrocknet sind.

Die derart erhältlichen Polymeren ergeben in Kombination mit den unterschiedlichsten negativ arbeitenden lichtempfindlichen Substanzen, wie Diazoniumsalz-Polykondensationsprodukten, photopolymerisierbaren Gemischen, Azidoderivaten oder Chinondiaziden leicht und schleierfrei entwickelbare Schichten, die je nach Art der Zusammensetzung mit Wasser, wäßrigen Lösungen unter Zusatz von geringen Mengen anorganischer Salze und/oder Tenside oder mit wäßrig-alkalischen Lösungen entwickelt werden können. Die Schichten zeichnen sich durch vergleichsweise hohe Abriebbeständigkeit, gute Farbannahme und praxisgerechte Lagerstabilität aus und sind daher für zahlreiche Anwendungsmöglichkeiten einsetzbar, insbesondere für die Herstellung lithographischer Platten, Siebdruckschablonen und Photoresists.

Die lichtempfindlichen Schichten enthalten bei derartigen Anwendungen 10 bis 90, bevorzugt 20 bis 75 Gew.-% der erfindungsgemäßen Polymeren.

Als negativ arbeitende lichthärtbare Substanzen lassen sich praktisch alle bekannten Verbindungen einsetzen, sofern sie mit der polymeren Matrix verträglich sind.

Beispielsweise sind Diazoniumsalz-Polykondensationsprodukte sehr gut geeignet, z. B. Kondensationsprodukte kondensationsfähiger aromatischer Diazoniumsalze mit Aldehyden, z. B. Kondensationsprodukte von Diphenylamin-4-diazoniumsalzen mit Formaldehyd. Vorteilhafterweise werden jedoch Mischkondensationsprodukte eingesetzt, welche außer den Diazoniumsalzeinheiten weitere, nicht lichtempfindliche Einheiten enthalten, die sich von kondensationsfähigen Verbindungen, z. B. aromatischen Aminen, Phenolen, Phenolethern, aromatischen Thioethern, aromatischen Kohlenwasserstoffen, aromatischen Heterocyclen oder organischen Säureamiden, ableiten. Derartige Kondensationsprodukte sind aus den DE-A 20 24 242, 20 24 243 und 20 24 244 bekannt. Allgemein sind jedoch alle Diazoniumsalz-Kondensate geeignet, welche in der DE-A 27 39 774 beschrieben sind. Der Mengenanteil des Diazoniumsalz-Polykondensationsprodukts in dem Gemisch liegt im allgemeinen zwischen 5 und 60, vorzugsweise zwischen 10 und 40 Gew.-%, bezogen auf den Gesamtgehalt an nichtflüchtigen Bestandteilen.

Weitere besonders vorteilhafte Polykondensationsprodukte werden erhalten, indem ein ggf. substituiertes Diphenylamindiazoniumsalz zuerst mit einer aromatischen Verbindung R'-O-CH₂-B und danach mit einer aromatischen Verbindung R'-O-CH₂-B-CH₂-O-R' kondensiert wird, wobei R' ein Wasserstoffatom, ein Alkyl- oder aliphatischer Acylrest und B der Rest einer der vorstehend aufgezählten kondensationsfähigen Verbindungen ist. Diese Kondensationsprodukte sind in der EP-A 126 875 beschrieben.

Auch photopolymerisierbare Gemische, bestehend aus einem polymerisierbaren Mono- oder Oligomeren und Photoinitiatoren sind vorteilhaft als lichtempfindliche Bestandteile im erfindungsgemäßen Gemisch einsetzbar, insbesondere im Anwendungsbereich gedruckter Schaltungen.

Geeignete polymerisierbare Verbindungen sind z. B. aus den US-A 2 760 683 und 3 060 023 bekannt. Beispiele sind Acryl- oder Methacrylsäureester mehrwertiger Alkohole, wie Trimethylolpropantriacrylat, Polyethylenglykoldiacrylat, Neopentylglykoldiacrylat, 2,2-Dimethylol-butan-3-ol-diacrylat, Pentaerythrittri- und -tetraacrylat sowie die entsprechenden Methacrylate. Geeignet sind ferner Acrylate oder Methacrylate, die Urethangruppen enthalten, sowie Acrylate bzw. Methacrylate hydroxylgruppenhaltiger Polyester. Schließlich sind auch Allyl- oder Vinylgruppen enthaltende Präpolymere geeignet, wobei insbesondere solche Monomeren oder Oligomeren bevorzugt werden, die mindestens zwei polymerisierbare Gruppen pro Molekül enthalten. Die polymerisierbaren Verbindungen können im allgemeinen in einer Menge von 5 bis 50, vorzugsweise von 10 bis 35 Gew.-%, bezogen auf die nichtflüchtigen Bestandteile, in dem erfindungsgemäßen Gemisch enthalten sein.

Als Photoinitiatoren im erfindungsgemäßen lichtempfindlichen Gemisch können zahlreiche Substanzen Verwendung finden. Beispiele sind Benzoine, Benzoinether, Mehrkernchinone, wie 2-Ethylanthrachinon, Acridinderivate, wie 9-Phenylacridin oder Benzacridine, Phenazinderivate, wie 9,10-Dimethylbenz(a)phenazin, Chinoxalin- oder Chinolinderivate, wie 2,3-Bis-(4-methoxyphenyl)chinoxalin oder 2-Styrylchinolin, Chinazolinverbindungen oder Acylphosphinoxidverbindungen. Photoinitiatoren dieser Art sind in den DE-C 20 27 467, 20 39 861 und der EP-B 11 786 beschrieben. Außerdem können beispielsweise Hydrazone, Mercaptoverbindungen, Pyrylium- oder Thiopyryliumsalze, synergistische Mischungen mit Ketonen oder Hydroxyketonen und Farbstoff-Redoxsysteme in Frage kommen. Besonders bevorzugt sind Photoinitiatoren, die durch Licht spaltbare Trihalogenmethylgruppen aufweisen, insbesondere entsprechende Verbindungen aus der Triazin- oder Thiazolinreihe. Solche Verbindungen sind in den DE-A 27 18 259, 33 33 450 und 33 37 024 beschrieben. Die Photoinitiatoren werden im allgemeinen in Mengenanteilen von 0,1 bis 15, vorzugsweise von 0,5 bis 10 Gew.-%, bezogen auf die nichtflüchtigen Bestandteile des Gemischs, zugesetzt.

Für gewisse Anwendungen sind als lichtempfindliche Verbindungen nieder- oder höhermolekulare Azidoderivate besonders geeignet, wobei niedermolekulare Azidoverbindungen mit mindestens zwei Azidogruppen pro Molekül bevorzugt werden. Als Beispiele seien 4,4'-Diazidostilbene, 4,4'-Diazidobenzophenone, 4,4'-Diazidobenzalacetophenone, 4,4'-Diazidobenzalacetone oder 4,4'-Diazidobenzalcyclohexanone genannt. Die Lichtempfindlichkeit derartiger Azidoverbindungen kann gegebenenfalls durch Verwendung geeigneter Sensibilisatoren, z. B. von 1,2-Benzanthrachinon, verstärkt werden. Weiterhin geeignet sind auch solche polyfunktionellen Azide, deren Eigenabsorption durch Konjugation mit Doppelbindungen im Molekül so verschoben ist, daß keine zusätzliche Sensibilisierung bei der Belichtung erforderlich ist. Weitere geeignete Azidoverbindungen sind aus der GB-A 790 131, der DE-C 950 618 und der US-A 2 848 328 bekannt. Der Mengenanteil des Azidoderivates in dem Gemisch liegt im allgemeinen zwischen 5 und 60, vorzugsweise zwischen 10 und 40 Gew.-%, bezogen auf den Gesamtgehalt an nichtflüchtigen Bestandteilen.

Schließlich lassen sich auch niedermolekulare Diazoverbindungen, wie p-Chinondiazide oder p-Iminochinondiazide als lichtempfindliche Verbindungen verwenden. Derartige Mischungen sind aber wegen der geringen Lichtempfindlichkeit nicht bevorzugt. Auch die Menge der niedermolekularen Diazoverbindungen kann im allgemeinen 5 bis 60, vorzugsweise 10 bis 40 Gew.-%, bezogen auf die nichtflüchtigen Bestandteile des Gemischs, betragen.

Die erfindungsgemäßen Gemische lassen sich auf bekannte Weise entsprechend ihrem Anwendungszweck verarbeiten. Dazu wird das polymere Umsetzungsprodukt in einem geeigneten Lösungsmittel oder Lösungsmittelgemisch, aus dem die Beschichtung erfolgen soll, z. B. Ethylenglykolmonoethylether, Ethylenglykolmonoacetat, Dioxan, Tetrahydrofuran oder Butanon, gelöst und mit einer in dieser Mischung löslichen lichtempfindlichen Substanz versetzt.

Des weiteren können je nach Art der lichtempfindlichen Verbindungen folgende Zusätze zur lichtempfindlichen Beschichtungslösung zugefügt werden:
a) bei Sensibilisierung mit Diazoverbindungen, z. B. p-Chinondiaziden oder Diazoniumsalz-Kondensationsprodukten:
   ein Farbstoff zum Sichtbarmachen der lichtempfindlichen Schicht auf dem Trägermaterial; eine Säure, bevorzugt Phosphorsäure, zur Stabilisierung des Diazoniumsalzes und ein Kontrastbildner, der eine Verstärkung der Farbänderung der Schicht bei Belichtung bewirkt.
b) bei Sensibilisierung mit Azidoverbindungen:
   ein Farbstoff, der zum Sichtbarmachen der lichtempfindlichen Schicht und zur Empfindlichkeitserhöhung der lichtvernetzenden Verbindung im gewünschten Spektralbereich beiträgt.
c) bei Sensibilisierung mit photopolymerisierbaren Substanzen:
   Inhibitoren, welche die thermische Polymerisation unterdrücken, oder Wasserstoffdonatoren.

Außerdem können dem lichtempfindlichen Gemisch Weichmacher, Pigmente, weitere Harzkomponenten usw. zugefügt werden. Zur Weiterverarbeitung werden die erhaltenen Lösungen filtriert, um gegebenenfalls ungelöste Bestandteile zu entfernen, und in an sich bekannter Weise, z. B. durch Rakeln oder Schleudern, auf ein geeignetes Trägermaterial aufgetragen und getrocknet. Als Trägermaterialien sind z. B. Aluminium, welches mechanisch oder elektrochemisch aufgerauht und ggf. anodisiert und nachbehandelt worden ist, aluminiumkaschierte oder andersartig hydrophilierte Folien, kupferbedampfte Folien oder Mehrmetallfolien geeignet. Die Art des Auftrags hängt in hohem Maß von der gewünschten Schichtdicke der lichtempfindlichen Schicht ab, wobei die Schichtdicken der getrockneten Schicht im allgemeinen zwischen 0,5 und 200µm liegen.

Nach ausreichender Trocknung können die Materialien in an sich bekannter Weise durch bildmäßige Belichtung mittels einer Negativ-Filmvorlage oder bei geeigneter Sensibilisierung mittels eines Laserstrahls und anschließende Entwicklung in ihre jeweilige Anwendungsform übergeführt werden. Die Entwicklung kann dabei mit Wasser, wäßrigen Lösungen, die gegebenenfalls geringe Mengen eines organischen Salzes und/oder Tensids enthalten oder mit wäßrig-alkalischen Lösungen durchgeführt werden. Die jeweils bevorzugte Entwicklungsart hängt von der Zusammensetzung des lichtempfindlichen Gemischs, von der Hydroxylzahl des erfindungsgemäßen Polymers und vom Anwendungszweck ab. Bevorzugt sind solche lichtempfindlichen Gemische, die sich mit Entwicklern verarbeiten lassen, die
a) ein Alkalisalz einer aliphatischen oder araliphatischen Sulfonsäure,
b) ein Alkaliborat,
c) ein Alkaliphosphat und
d) ggf. ein Alkalisalz einer organischen aromatischen Carbonsäure, z. B. Benzoesäure,
enthalten. In einigen Fällen ist es günstig, das belichtete und entwickelte Gemisch mit einem Konservierungsmittel zu behandeln.

Durch eine thermische Nachbehandlung kann die Schicht zusätzlich verfestigt werden, was insbesondere bei Anwendungen als Flachdruckformen sinnvoll ist. Zu diesem Zweck wird die konservierte Druckform auf Temperaturen zwischen 180 und 240° C erwärmt. Die Dauer dieser Behandlung ist abhängig von der Temperatur und schwankt zwischen 2 und 20 Minuten.

Diese thermische Nachbehandlung unterscheidet sich insofern von vorbeschriebenen Nachbehandlungen ähnlicher Art, als sie keinen Zusatz eines Vernetzungsmittels erfordert. Es wird angenommen, daß die erfindungsgemäßen Polymeren unter diesen Bedingungen Wasser abspalten und in Polymere mit ungesättigten Seitengruppen übergehen, die einer zusätzlichen photochemischen oder thermischen Vernetzung zugänglich sind. Es kann daher sinnvoll sein, dem lichtempfindlichen Gemisch zusätzlich einen thermischen Vernetzer zuzufügen, z. B. ein organisches Peroxid mit einer Scorch-Temperatur von mindestens 100° C, das oberhalb dieser Temperatur befähigt ist, Radikale zu bilden. Geeignete Peroxide sind Peroxyester, Peroxyketale, Bis-aralkyl-peroxide, Dialkylperoxide und Bis-dialkyl-peroxide. Durch diese thermische Nachbehandlung wird das Farbannahmeverhalten der lichtempfindlichen Schicht erheblich verbessert, insbesondere dann, wenn solche Polymeren eingesetzt werden, die eine hohe Hydroxylzahl aufweisen.

Die erfindungsgemäßen Gemische erlauben die Herstellung von Flachdruckformen, die sich durch verhältnsmäßig hohe Auflagen, gute Wiedergabeeigenschaften und praxisgerechte Lagerstabilität auszeichnen. Sie sind leicht und schleierfrei mit Entwicklerlösungen verarbeitbar, die praktisch umweltneutral sind. Durch die vorstehend beschriebene thermische Nachbehandlung kann eine erhebliche Steigerung der Abriebbeständigkeit erzielt werden. Sie erlauben ferner die Herstellung von Resistschablonen ausgezeichneter Auflösung, die eine ausreichende Wärmestandfestigkeit aufweisen und eine ausreichende Lagerstabilität gewährleisten. Auch in diesem Fall können sehr milde, wenig oder nicht toxische Entwicklerlösungen verwendet werden. Schließlich ist als Anwendungsbereich noch die Herstellung von Siebdruckschablonen zu benennen. Auch hier sind als besondere Vorteile wieder die günstige Verarbeitbarkeit und die gute Lagerstabilität des Gemischs zu nennen.

Die nachstehenden Beispiele sollen die Erfindung und ihre Anwendungsmöglichkeiten näher erläutern. Gewichtsteile (Gt) und Volumenteile (Vt) stehen im Verhältnis von g/cm³; Prozentzahlen und Mengenverhältnisse sind, wenn nicht anders angegeben, in Gewichtsteilen zu verstehen.

### Herstellungsbeispiel 1

Durch alkalikatalysierte Kondensation von Acetaldehyd wird Acetaldol (3-Hydroxybutanal) hergestellt (vgl. Organikum, VEB Deutscher Verlag der Wissenschaften, Berlin, 15. Aufl. 1977, S. 566) und durch Zusatz einer geringen Menge Wasser stabilisiert.

44 Gt Polyvinylalkohol (12 % Restacetylgruppen; K-Wert 8) werden in 300 Vt Ethanol eingetragen. Die Mischung wird mit einem Rührer mit 450 Umdrehungen je Minute gerührt. Dazu werden 26,2 Gt Acetaldol, 14,4 Gt Butanal und 0,3 Gt 2,6-Di-t-butylkresol (Ionol) gegeben. Diese Mischung wird unter Rühren mit 0,5 Gt Schwefelsäure versetzt und zum Rückfluß erhitzt. Dabei geht der Polyvinylalkohol in Lösung. Nach 4 Stunden werden nochmals 5,0 Gt Butanal hinzugefügt, und das Gemisch wird weitere 3 Stunden zum Rückfluß erhitzt. Die erkaltete Lösung wird mit 300 Vt Ethanol versetzt und in 10.000 Gt entsalztem Wasser ausgefällt. Man erhält ein amorphes, faseriges, weißes Produkt, das 60,9 % C und 9,5 % H enthält und die OH-Zahl 373 aufweist.

### Herstellungsbeispiel 2

Durch säurekatalysierte Spaltung von 2,3-Dihydropyran wird 5-Hydroxypentanal hergestellt (vgl. Org. Synth., Coll. Vol. III, S. 470).

44 Gt des im Herstellungsbeispiel 1 angegebenen Polyvinylalkohols werden in 340 Vt Wasser in der Wärme gelöst. Zu der erkalteten, gut gerührten Lösung werden 36,7 Gt 5-Hydroxypentanal und 6,5 Gt Butanal sowie 0,3 Gt 2,6-Di-t-butylkresol gegeben. Zu dieser Mischung wird eine Lösung aus 80 Vt destilliertem Wasser, 7 Vt konzentrierter Salzsäure und 0,5 Gt Natriumoctylsulfat zugetropft. Die Mischung wird eine Stunde bei Raumtemperatur gerührt, wobei sie eintrübt und das polymere Umsetzungsprodukt in Form eines körnigen Niederschlags auszufallen beginnt. Das Gemisch wird auf 40° C erwärmt und zwei Stunden bei dieser Temperatur belassen, anschließend werden 20 Vt konzentrierte Salzsäure zufließen gelassen, es wird weitere zwei Stunden bei 40° C gerührt und unter Rühren auf Raumtemperatur abkühlen gelassen. Die überstehende Lösung wird abdekantiert, das Produkt mit viel Wasser gewaschen und dann in einem Gemisch aus 350 Vt Ethylenglykolmonomethylether und 200 Vt Tetrahydrofuran gelöst. Die klare Lösung wird in 10.000 Vt Wasser, welches 3 Gew.-% Natriumhydrogensulfit enthält, eingetropft. Das ausgefallene Produkt wird durch Filtration isoliert, gut mit Wasser gewaschen und getrocknet. Es werden 70 Gt eines weißen, faserigen Polymeren erhalten, das 58,9 % C und 9,2 % H enthält und die OH-Zahl 338 aufweist.

### Herstellungsbeispiel 3

Durch alkalikatalysierte Umsetzung von Acetaldehyd mit Propionaldehyd wird 3-Hydroxypentanal hergestellt.

44 Gt Polyvinylalkohol (2 % Restacetylgruppen; K-Wert 10) werden entsprechend Herstellungsbeispiel 1 mit 29 Gt 3-Hydroxypentanal und 16 Gt Propanal umgesetzt. Man erhält ein etwas spröderes, weißes, faseriges Material in einer Ausbeute von 82 Gt mit der OH-Zahl 292.

### Herstellungsbeispiel 4

Aus 2,3-Dihydrofuran wird 4-Hydroxybutanal hergestellt.

44 Gt Polyvinylalkohol (12 % Restacetylgruppen; K-Wert 4) werden entsprechend Herstellungsbeispiel 2 mit 18,6 Gt 4-Hydroxybutanal und 19,4 Gt Acetaldehyd umgesetzt. Dabei werden allerdings zunächst das gesamte Hydroxybutanal und nur 30 % des Acetaldehyds vorgelegt. Der Rest des Acetaldehyds wird erst dann zugegeben, wenn die Mischung aus Säure und Natriumoctylsulfat vollständig eingetropft ist und erste Anzeichen einer Trübung des Reaktionsgemischs sichtbar werden. Man erhält 76 Gt eines weißen, faserigen Produkts, das die OH-Zahl 244 hat und 59,2 % C und 9,0 % H enthält.

### Herstellungsbeispiel 5

Aus Propionaldehyd wird 2-Methyl-3-hydroxypentanal hergestellt.

44 Gt Polyvinylalkohol ( 2 % Restacetylgruppen; K-Wert 4) werden entsprechend Herstellungsbeispiel 1 mit 30 Gt 2-Methyl-3-hydroxypentanal und 15 Gt Benzaldehyd umgesetzt. Man erhält ein faseriges, weißes Polymeres mit der OH-Zahl 302.

### Herstellungsbeispiel 6

Entsprechend Herstellungsbeispiel 1 werden 44 Gt des im Herstellungsbeispiel 1 angegebenen Polyvinylalkohols mit 29 Gt 3-Hydroxybutanal und 7,4 Gt 4-Formylbenzoesäuremethylester umgesetzt. Nach Beendigung der Reaktion wird abkühlen gelassen und die Mischung tropfenweise mit 25 Vt 30 %iger Natronlauge versetzt. Es wird eine Stunde bei Raumtemperatur nachgerührt, mit 350 Vt Ethanol verdünnt und in 10.000 Gt 0,01 n wäßrige HCl eingetropft. Das ausgefällte faserige Polymer wird abgehebert, mit reichlich Wasser neutral gewaschen und getrocknet. Man erhält ein Polymeres mit der Säurezahl 29 und der OH-Zahl 470.

### Herstellungsbeispiel 7

Der Polyvinylalkohol des Herstellungsbeispiels 1 wird in dem dort angegebenen Mengenverhältnis mit Acetaldol und Butanal umgesetzt, wobei aber die Reaktionsbedingungen des Herstellungsbeispiels 2 angewendet werden. Das erhaltene Produkt fällt in 95 %iger Ausbeute an und enthält 60,8 % C und 9,3 % H. Es weist die OH-Zahl 359 auf.

### Herstellungsbeispiel 8

Entsprechend Herstellungsbeispiel 1 werden 44 Gt des Polyvinylalkohols von Herstellungsbeispiel 1 mit 26 Gt Butanal und 9 Gt 5-Hydroxypentanal umgesetzt. Das erhaltene Polymere hat 62,5 % C, 9,5 % H und die OH-Zahl 219.

### Herstellungsbeispiel 9

Eine Mischung aus 32 Gt des im Herstellungsbeispiel 1 angegebenen Polyvinylalkohols und 12 Gt Polyvinylalkohol mit 12 % Restacetylgruppen und dem K-Wert 18 wird wie im Herstellungsbeispiel 2 beschrieben mit 17,6 Gt 3-Hydroxybutanal und 3,6 Gt Butanal umgesetzt. Das erhaltene Polymere hat die OH-Zahl 426 und enthält 60,5 % C und 9,5 % H.

### Herstellungsbeispiel 10

44 Gt Polyvinylalkohol ( 2 % Restacetylgruppen; K-Wert 8) werden entsprechend Herstellungsbeispiel 2 mit 20 Gt 3-Hydroxypentanal und 10 Gt 4-Chlorbenzaldehyd umgesetzt. Man erhält ein Polymeres mit der OH-Zahl 252 und einem Chlorgehalt von 2,7 %.

### Herstellungsbeispiel 11

Durch Umsetzung von Bromacetaldehyddiethylacetal mit Phenol wird 2-Phenoxyacetaldehyddiethylacetal hergestellt, welches durch saure Hydrolyse in den Aldehyd übergeführt wird. 44 Gt des im Herstellungsbeispiel 5 angegebenen Polyvinylalkohols werden entsprechend Herstellungsbeispiel 1 mit 15 Gt 3-Hydroxyhexanal und 25 Gt des vorstehend beschriebenen Aldehyds umgesetzt. Das erhaltene Polymere hat die OH-Zahl 187 und enthält 63,2 % C und 8,9 % H.

### Herstellungsbeispiel 12

44 Gt des im Herstellungsbeispiel 5 angegebenen Polyvinylalkohols werden entsprechend Herstellungsbeispiel 2 nach Vorlage der Säure tropfenweise mit 18 Gt einer 37 %igen wäßrigen Formaldehydlösung versetzt. Nach beendetem Zutropfen werden dem Gemisch 22 Gt 2,2-Dimethyl-3-hydroxybutanal zugefügt, und es wird wie im Herstellungsbeispiel 2 angegeben weitergearbeitet. Man erhält ein sprödes Produkt mit der OH-Zahl 274.

### Herstellungsbeispiele 13 und 14

Der Benzaldehyd des Herstellungsbeispiels 5 wird durch die gleiche Menge eines Gemischs aus gleichen Teilen 4-Methylbenzaldehyd und 4-Methoxybenzaldehyd ersetzt. Die erhaltenen Polymeren weisen OH-Zahlen um 270 auf und sind in ihren Eigenschaften dem Polymeren des Herstellungsbeispiels 5 sehr ähnlich.

### Herstellungsbeispiel 15

Aus Formaldehyd und 2-Methylpropanal wird 2-Methyl-2-methylolpropanal hergestellt. 44 Gt des im Herstellungsbeispiel 1 angegebenen Polyvinylalkohols werden mit 24 Gt 2-Methyl-2-methylolpropanal und 16 Gt Butanal entsprechend Herstellungsbeispiel 2 umgesetzt. Das erhaltene, ausgefällte Polymere ist bei Lagerung unterhalb 30° C stabil. Es hat die OH-Zahl 322.

### Herstellungsbeispiel 16

44 Gt des im Herstellungsbeispiel 5 angegebenen Polyvinylalkohols werden mit 46 Gt 5-Hydroxypentanal und 2 Gt Butanal entsprechend Herstellungsbeispiel 1 umgesetzt. Das Polymere hat die OH-Zahl 442.

### Herstellungsbeispiel 17

Durch alkalikatalysierte Kondensation von n-Butanal wird 2-Ethyl-3-hydroxyhexanal hergestellt. 22 Gt des im Herstellungsbeispiel 5 angegebenen Polyvinylalkohols und 22 Gt des im Herstellungsbeispiel 4 angegebenen Polyvinylalkohols werden mit 20 Gt 2-Ethyl-3-hydroxyhexanal und 8 Gt Propanal umgesetzt. Das Polymere hat die OH-Zahl 324.

### Anwendungsbeispiel 1

Eine Beschichtungslösung aus
3,5 Gt des im Herstellungsbeispiel 1 beschriebenen Polymeren,
1,2 Gt eines Diazoniumsalz-Polykondensationsprodukts, hergestellt aus 1 mol 3-Methoxy-diphenylamin-4-diazoniumsulfat und 1 mol 4,4'-Bis-methoxymethyl-diphenylether in 85%iger Phosphorsäure und isoliert als Mesitylensulfonat,
0,14 Gt Phosphorsäure (85 %),
0,18 Gt Viktoriareinblau FGA (C.I.Basic Blue 81) und
0,04 Gt Phenylazodiphenylamin in
165 Gt Ethylenglykolmonomethylether und
32 Gt Tetrahydrofuran
wird auf eine 0,3 mm starke Aluminiumfolie, welche durch Bürsten mit einer wäßrigen Schleifmittelsuspension aufgerauht und danach mit einer 0,1 %igen wäßrigen Lösung von Polyvinylphosphonsäure vorbehandelt worden ist, aufgebracht und anschließend getrocknet.

Die so erhaltene lichtempfindliche Schicht, die ein Schichtgewicht von 0,6 g/m² aufweist, wird unter einer Standard-Negativvorlage 18 Sekunden mit einer Metallhalogenid-Lampe von 5 kW Leistung belichtet. Die belichtete Schicht zeigt einen klaren Kontrast zwischen den belichteten und nichtbelichteten Bereichen und wird mit einer Entwicklerlösung folgender Zusammensetzung:
3,0 Gt Natriumoctylsulfat,
4,2 Gt Natriumbenzoat,
2,8 Gt Trinatriumphosphat x 12 Wasser,
1,5 Gt Mononatriumdihydrogenphosphat,
88,5 Gt entsalztes Wasser,
deren pH 7,3 beträgt, behandelt, wobei die nichtbelichteten Schichtbereiche innerhalb kurzer Zeit sauber entfernt werden, und anschließend mit Wasser abgespült und getrocknet. In der Kopie werden die feinsten Elemente der Vorlage wiedergegeben. Die derart erhaltene Druckplatte liefert an einer Bogenoffsetmaschine eine Auflage von mehr als 50.000 Bögen.

### Anwendungsbeispiel 2

Eine Beschichtungslösung aus
92,2 Gt des im Herstellungsbeispiel 1 beschriebenen Bindemittels,
31,9 Gt des im Anwendungsbeispiel 1 beschriebenen Diazoniumsalz-Polykondensats, das jedoch als Methansulfonat isoliert worden ist,
3,85 Gt Phosphorsäure (85 %),
4,73 Gt Viktoriareinblau FGA und
1,1 Gt Phenylazodiphenylamin in
4600 Gt Ethylenglykolmonomethylether
wird auf den im Anwendungsbeispiel 1 beschriebenen Schichtträger aufgebracht. Das Trockenschichtgewicht beträgt 0,55 g/m².

Die Belichtung erfolgt wie im Anwendungsbeispiel 1 angegeben, während man zur Entwicklung mit Wasser überspült und mit einem mit Wasser getränkten Plüschtampon überwischt. Die Nichtbildbereiche lassen sich problemlos entfernen, und man erhält nach Konservierung mit einer wäßrigen Lösung, die 3 % Polystyrolsulfonsäure enthält, eine gut farbannehmende Druckform, deren Nichtbildbereiche keine fette Farbe annehmen. Beim Auflagendruck in einer Bogenoffsetmaschine erhält man einige Tausend guter Drucke.

### Anwendungsbeispiel 3

Eine Beschichtungslösung wird bereitet aus
2 Gt des im Herstellungsbeispiel 1 beschriebenen Polymeren,
2,2 Gt des Umsetzungsprodukts aus 1 mol 2,2,4-Trimethyl-hexamethylendiisocyanat und 2 mol Hydroxyethylmethacrylat,
0,1 Gt 9-Phenylacridin,
0,1 Gt des Azofarbstoffs aus 2,4-Dinitro-6-chlorbenzoldiazoniumsalz und 2-Methoxy-5-acetylamino-N-cyanoethyl-N-hydroxyethylanilin in
26 Gt Butanon und
14 Gt Butylacetat.

Die Lösung wird auf eine in Salpetersäure elektrochemisch aufgerauhte, in Schwefelsäure anodisierte und mit Polyvinylphosphonsäure nachbehandelte Aluminiumfolie derart aufgebracht, daß ein Trockenschichtgewicht von 3,2 g/m² erhalten wird. Die Schicht wird anschließend zum Schutz ihrer Oberfläche mit einer 0,4 µm starken Schicht von Polyvinylalkohol überzogen.

Die fertige Platte wird 20 Sekunden mit einer 5 kW-Metallhalogenid-Lampe im Abstand von 130 cm zwischen Kopierrahmen und Lampe unter einem Halbtonstufenkeil mit einem Dichteumfang von 0,05 bis 3,05 und Dichteinkrementen von 0,15 belichtet. Die Entwicklung erfolgt mit einem Entwickler folgender Zusammensetzung:
1 Gt NaOH,
4 Gt Pelargonsäure,
12 Gt eines Ethylenoxid/Propylenoxid-Copolymeren,
4 Gt Natriumtetrapolyphosphat und
79 Gt Wasser.

Die rasch entwickelbare Platte zeigt eine gedeckte Stufe 4.

Nach dem Einspannen in eine Bogenoffsetmaschine werden 125.000 gute Drucke erhalten.

### Anwendungsbeispiel 4

Es wird eine Beschichtungslösung bereitet aus
2,1 Gt des im Herstellungsbeispiel 2 beschriebenen Polymeren,
2,2 Gt 2,6-Bis(4-azidobenzal)-4-methylcyclohexanon,
0,3 Gt Rhodamin 6 GDN extra (C.I. 45160) in
120 Gt Ethylenglykolmonomethylether und
30 Gt Butanon.

Die Lösung wird auf den im Anwendungsbeispiel 3 beschriebenen Träger aufgebracht und zu einem Trockenschichtgewicht von 0,7 g/m² getrocknet. Nach der Belichtung wird ein gut sichtbares dunkelrotes Bild erhalten. Die Schicht wird mittels eines Plüschtampons mit einer Entwicklerlösung aus
5,0 Gt Natriumlaurylsulfat und
1,0 Gt Natriummetasilikat x 5 Wasser in
94,0 Gt entsalztem Wasser
behandelt, wobei die Nichtbildstellen entfernt werden. In einer Bogenoffsetmaschine werden 156.000 gute Drucke erhalten.

### Anwendungsbeispiel 5

Die Schicht des vorhergehenden Beispiels wird nach Belichtung, Entwicklung und Konservierung mit einem handelsüblichen Konservierungsmittel in einem Wärmeschrank 5 Minuten auf 230° C erhitzt. Diese Platte druckt im direkten Vergleich zu der Platte des vorhergehenden Beispiels 110.000 Drucke mehr.

### Anwendungsbeispiel 6

Eine Beschichtungslösung aus
30,3 Gt des im Herstellungsbeispiel 5 beschriebenen Polymeren,
15,1 Gt des im Anwendungsbeispiel 1 beschriebenen Diazoniumsalz-Polykondensationsprodukts,
1,2 Gt Phosphorsäure (85 %),
1,5 Gt Victoriareinblau FGA (C.I. Basic Blue 81) und
1,1 Gt Phenylazodiphenylamin in
1600 Gt Ethylenglykolmonomethylether
wird auf eine elektrolytisch in Salzsäure aufgerauhte, dann anodisierte und mit Polyvinylphosphonsäure nachbehandelte Aluminiumfolie durch Schleudern aufgebracht. Das Schichtgewicht der getrockneten Schicht beträgt 1,2 g/m².

Die Belichtung und Entwicklung erfolgt wie im Anwendungsbeispiel 1 angegeben.

Die erhaltene Druckform druckt in einer Bogenoffsetmaschine eine Druckauflage von 150.000 Bögen, ohne daß eine signifikante Abnutzung der Kopie sichtbar wird.

### Anwendungsbeispiel 7

Aus
6,5 Gt des im Herstellungsbeispiel 7 beschriebenen Umsetzungsprodukts,
5,6 Gt eines technischen Gemischs aus Pentaerythrittri- und -tetraacrylat,
0,2 Gt 2-(4'-Methoxystyryl)-4,6-bis-trichlormethyl-s-triazin und
0,03 Gt des im Anwendungsbeispiel 3 angegebenen Azofarbstoffs in
25 Gt Butanon,
2 Gt Ethanol und
1 Gt Butylacetat
wird eine Lösung bereitet, die auf eine biaxial verstreckte und thermofixierte Polyethylenterephthalatfolie der Stärke 25 µm so aufgeschleudert wird, daß nach dem Trocknen bei 100°C ein Trockenschichtgewicht von 35 g/m² erhalten wird.

Die derart hergestellte Trockenresistfolie wird mit einer Laminiervorrichtung bei 120° C auf eine mit 35µm starker Kupferfolie kaschierte Phenoplast-Schichtstoffplatte laminiert und 25 Sekunden unter einem handelsüblichen Belichtungsgerät belichtet. Als Vorlage dient eine Strichvorlage mit Linienbreiten und Abständen bis herab zu 80µm. Nach der Belichtung wird die Polyesterfolie langsam abgezogen und die erhaltene Schicht mit einer Entwicklerlösung der im Anwendungsbeispiel 1 angegebenen Zusammensetzung in einem Sprühentwicklungsgerät 90 Sekunden entwickelt. Anschließend wird 30 Sekunden mit Leitungswasser gespült, 30 Sekunden in einer 15 %igen Ammoniumperoxydisulfatlösung angeätzt und anschließend in folgenden Elektrolytbädern galvanisiert:
1) 30 Minuten in einem Kupferbad der Fa. Schlötter, Geislingen/Steige, Typ "Glanzkupfer-Bad".
   Stromdichte: 2,5 A/dm².
   Metallaufbau: ca. 12,5µm
2) 10 Minuten in einem Nickelbad des gleichen Herstellers, Typ "Norma".
   Stromdichte: 4,0 A/dm².
   Metallaufbau: 9µm.

Die Platte zeigt keine Beschädigungen oder Unterwanderungen. Die Entschichtung erfolgt in 5 %iger KOH-Lösung bei 50° C. Das freigelegte Kupfer wird mit den üblichen Ätzmedien weggeätzt.

### Anwendungsbeispiel 8

Es wird eine Beschichtungslösung nachstehender Zusammensetzung hergestellt:
1,5 Gt des im Herstellungsbeispiel 9 beschriebenen Polymeren,
0,5 Gt eines Diazoniumsalz-Polykondensationsprodukts aus 1 mol 3-Methoxy-diphenylamin-4-diazoniumsulfat und je 1 mol 4-Methoxymethyl-4'-methyl-diphenylether und 1,4- Bis-methoxymethylbenzol, ausgefällt als 2-Hydroxy-4-methoxy-benzophenon-5-sulfonat,
0,1 Gt Viktoriareinblau FGA,
1,5 Gt technisches Gemisch von Pentaerythrittri-und -tetraacrylat,
0,1 Gt 2-(4'-Styrylphenyl)-4,6-bis-trichlormethyl-s-triazin und
0,05 Gt Phosphorsäure (85 %) in
48 Gt Ethylenglykolmonomethylether und
42 Gt Butanon.

Diese Lösung wird auf eine elektrochemisch aufgerauhte, anodisierte und mit Polyvinylphosphonsäure nachbehandelte Aluminiumplatte aufgetragen und zu einem Trockenschichtgewicht von 1,6 g/m² getrocknet. Die erhaltene Druckplatte wird unter einer geeigneten Testvorlage belichtet und mit einem Entwickler nachstehender Zusammensetzung entwickelt:
3,5 Gt Dinatriumhydrogenphosphat x 12 Wasser,
3,5 Gt Trinatriumphosphat x 12 Wasser,
1,5 Gt Kaliumtetraborat x 4 Wasser und
2,5 Gt Natriumdodecylsulfat in
89,0 Gt entsalztem Wasser.

Die Druckform nimmt in der Bogenoffsetdruckmaschine sofort fette Farbe an. Auch nach längerem Maschinenstillstand wird die Farbe bereits nach 2 - 8 Bögen wieder voll angenommen. Die erzielte Druckauflage beträgt ca. 180.000 einwandfreie Drucke, wobei auch feinste Linien noch voll wiedergegeben werden.

### Anwendungsbeispiel 9

Der Beschichtungslösung des vorstehenden Beispiels werden zusätzlich 0,2 Gt 2,5-Dimethylhexan-2,5-di-t-butylperoxid als 45 %iges Granulat mit Kreide einverleibt, und die Lösung wird vor dem Beschichten filtriert. Die entwickelte Druckform wird mit einem handelsüblichen Konservierungsmittel behandelt und 5 Minuten auf 210° C erwärmt. Die derart thermisch nachbehandelte Platte zeigt auch bei 300.000 Bögen noch keinerlei Schädigungen.

### Anwendungsbeispiel 10

Die im Anwendungsbeispiel 6 beschriebene Schicht wird auf ihre Lagerfähigkeit geprüft. Dazu werden von dem dort beschriebenen lichtempfindlichen Gemisch 5 Platten hergestellt und diese 1 bis 5 Stunden in einem Trockenschrank bei 100° C gelagert. Nach der Wärmelagerung werden die Platten bildmäßig belichtet und mit dem im Anwendungsbeispiel 1 beschriebenen Entwickler entwickelt. Zum Sichtbarmachen von verbliebenen Schichtresten (Ton) in den Nichtbildbereichen werden die getrockneten Platten mit Schutzfarbe eingefärbt.

Die eine und zwei Stunden gelagerten Platten lassen sich noch einwandfrei entwickeln. Sie zeigen keine nennenswerte Verlängerung des Halbtonstufenkeils. Nach dreistündiger Wärmelagerung zeigt die Schicht eine Verlängerung des Halbtonstufenkeils um gut 2 Stufen. Die Entwicklung ist nur leicht verzögert. Die vier Stunden gelagerte Platte läßt sich nur merklich verzögert und unter Fladenbildung entwickeln. Die fünf Stunden gelagerte Platte tont, und die Schicht läßt sich an keiner Stelle mehr einwandfrei vom Schichtträger ablösen. Die Ergebnisse zeigen, daß die erfindungsgemäßen Gemische gegen Lagerung in der Wärme relativ beständig sind.

### Anwendungsbeispiele 11 bis 16

Anhand der nachstehenden Beispiele soll verdeutlicht werden, daß die erfindungsgemäßen lichtempfindlichen Schichten gegenüber solchen, die handelsübliche Polyvinylacetale mit zumeist geringerer Hydroxylzahl enthalten, leichter mit wäßrigen Entwicklern verarbeitbar sind und dabei gleichzeitig kopier- und drucktechnische Eigenschaften aufweisen, die denen der Vergleichsbeispiele überlegen oder zumindest ebenbürtig sind.

Zu diesem Zweck werden 6 Beschichtungslösungen hergestellt, die sich lediglich im verwendeten Polymeren unterscheiden:
3,6 Gt des jeweiligen Polymeren,
1,8 Gt des im Anwendungsbeispiel 1 beschriebenen Diazoniumsalz-Polykondensationsprodukts,
0,2 Gt Phosphorsäure (85 %)
0,1 Gt Kristallviolett (C.I. 42555) und
0,06 Gt Phenylazodiphenylamin in
150 Gt Ethylenglykolmonomethylether.

Die jeweils verwendeten Polymeren, deren OH-Zahlen sowie die Entwickelbarkeit, Auflösung, Farbannahme, Druckauflage und Druckauflage nach Wärmenachbehandlung der entsprechenden lichtempfindlichen Schichten sind in der nachstehenden Tabelle 1 wiedergegeben. Alle Schichten werden zu einem Trockenschichtgewicht von 1,0 g/m² auf einen elektrolytisch in Salpetersäure aufgerauhten, anodisierten und mit Polyvinylphosphonsäure nachbehandelten Aluminiumträger aufgebracht.

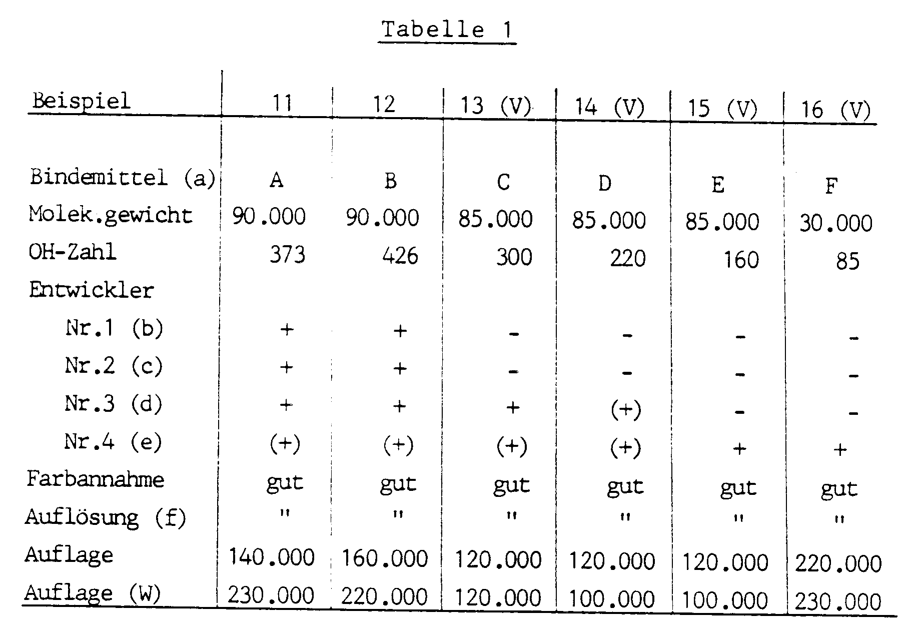

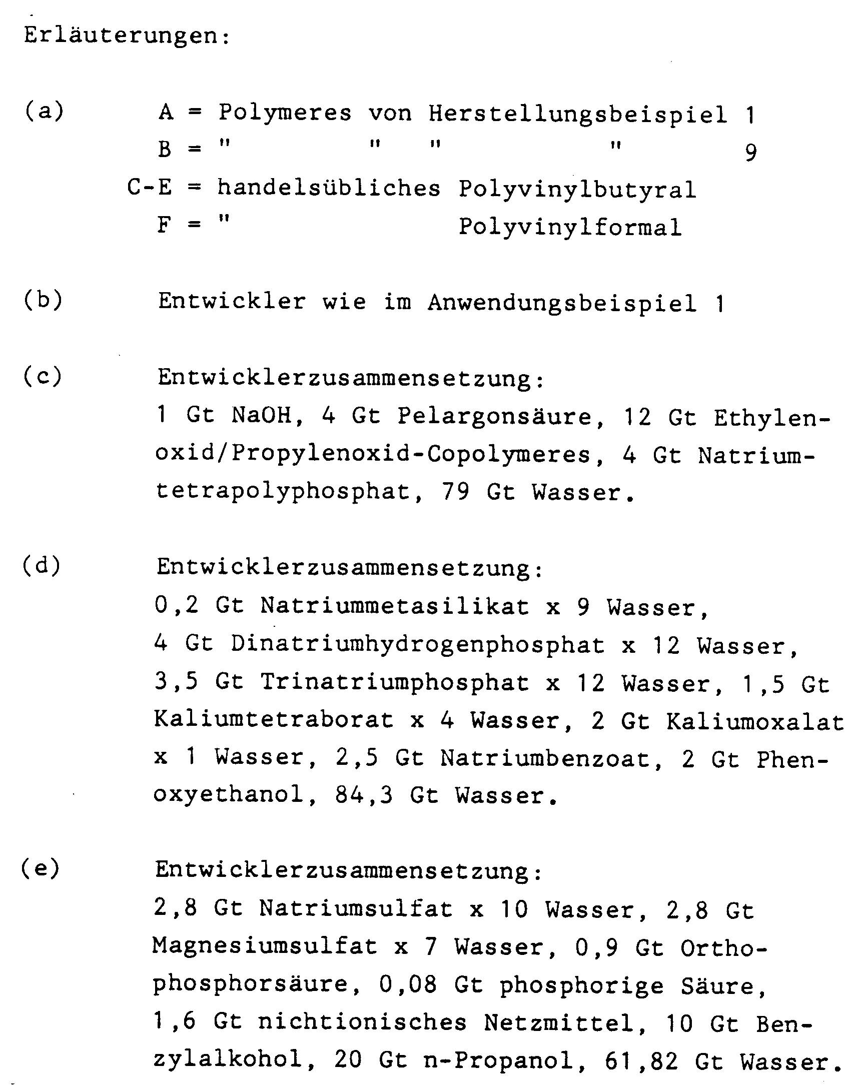

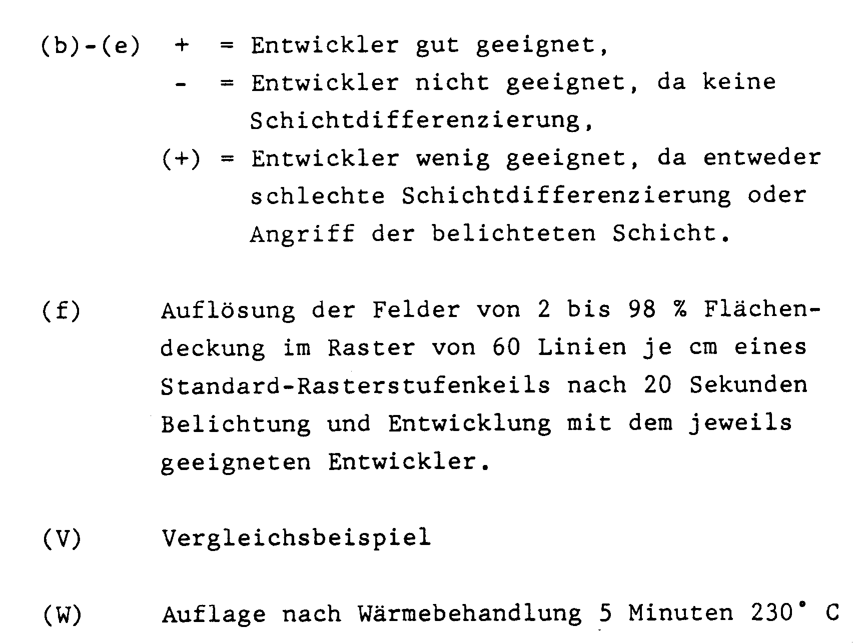

Aus diesen Beispielen geht hervor, daß die erfindungsgemäßen lichtempfindlichen Gemische im Gegensatz zu den Gemischen der Vergleichsbeispiele leicht mit wäßrigen Lösungen entwickelbar sind. Die letzteren lassen sich erst mit wäßrig-alkalischen, i. a. lösungsmittelhaltigen Entwicklern verarbeiten. Die Polyvinylformal enthaltende Schicht läßt sich nur mit einem Entwickler verarbeiten, der einen hohen Anteil an Lösungsmitteln aufweist. Die erfindungsgemäßen Schichten entsprechen kopiertechnisch denen der Vergleichsbeispiele und sind in ihrer Auflage diesen entweder überlegen oder zumindest gleichwertig.

### Anwendungsbeispiel 17

Es wird eine Beschichtungslösung bereitet aus
2,2 Gt des im Herstellungsbeispiel 9 beschriebenen Polymeren,
2,2 Gt 4,4'-Diazidostilben-2,2'-disulfonsäure,
0,3 Gt Rhodamin 6 GDN extra und
0,2 Gt 2-Benzoylmethylen-1-methyl-β-naphthothiazolin in
100 Gt Ethylenglykolmonomethylether,
30 Gt Tetrahydrofuran und
20 Gt Wasser.

Die Lösung wird auf den im Anwendungsbeispiel 3 beschriebenen Träger aufgebracht und zu einem Trockenschichtgewicht von 0,8 g/m² getrocknet. Die Kopierschicht wird 35 Sekunden unter einer Negativvorlage mit einer Metallhalogenidlampe von 5 kW Leistung belichtet. Die Schicht wird mit einer Lösung aus
5 Gt Natriumlaurylsulfat und
95 Gt Wasser
durch Überwischen mit einem Plüschtampon entwickelt, wobei die Nichtbildstellen entfernt werden. An der Bogenoffsetmaschine werden 175.000 qualitativ gute Drucke erzielt.

### Anwendungsbeispiel 18

Die im Anwendungsbeispiel 1 beschriebene Beschichtungslösung wird auf den im Anwendungsbeispiel 3 beschriebenen Träger aufgeschleudert. Das Schichtgewicht beträgt nach dem Trocknen etwa 1 g/m². Vier Platten dieses Typs werden in einem Tropenschrank gelagert, der auf 40° C erwärmt ist und eine relative Feuchtigkeit von 60 % aufweist. Jeweils eine Platte wird nach 1, 2, 4 und 8 Monaten herausgenommen, bildmäßiig belichtet und wie im Anwendungsbeispiel 1 beschrieben entwickelt. Zum Vergleich wird eine nicht diesen Bedingungen ausgesetzte Platte herangezogen.

Die 1 und 2 Monate gelagerten Platten entsprechen vollkommen der Originalplatte. Sie lassen sich ebenso rasch und schleierfrei entwickeln. Die 4 Monate gelagerte Platte zeigt eine deutliche Halbtonstufenkeil-Verlängerung. Die 8 Monate gelagerte Platte zeigt auch in den Nichtbildbereichen Spuren von Ton. Für eine mit wäßrigen Lösungen entwickelbare Schicht ist eine derartige Lagerbeständigkeit überraschend hoch.

### Anwendungsbeispiel 19

Eine Beschichtungslösung aus
6,5 Gt des im Herstellungsbeispiel 6 beschriebenen Polymeren,
5,5 Gt 4,4'-Bis-(β-acryloyloxyethoxy)diphenylether,
0,2 Gt 2-(4'-Methoxystyryl)-4,6-bis-trichlormethyl-s-triazin und
0,2 Gt des im Anwendungsbeispiel 3 angegebenen Azofarbstoffs in
250 Gt Butanon,
2 Gt Ethanol und
1 Gt Butylacetat
wird, wie im Anwendungsbeispiel 7 beschrieben, weiterverarbeitet. Auch diese Platte zeigt keine Beschädigungen oder Unterwanderungen.

### Anwendungsbeispiel 20

Ein entfettetes Polyestersieb (Maschenweite 0,05 mm) wird mit folgender Beschichtungslösung versetzt:
4,5 Gt des im Herstellungsbeispiel 5 beschriebenen Polymeren,
2,0 Gt Dipentaerythritpentaacrylat,
2,0 Gt eines Urethanacrylats, hergestellt durch Umsetzung von 1 mol Toluol-2,4-diisocyanat mit 2 mol Hydroxyethylmethacrylat und
0,4 Gt 2-(4-Ethoxy-naphth-1-yl)-4,6-bis-trichlormethyl-s-triazin in
92 Gt Ethylenglykolmonomethylether.

Das getrocknete Sieb wird durch eine Photomaske belichtet und mit dem im Anwendungsbeispiel 1 angegebenen Entwickler verarbeitet. Die erhaltene Siebdruckschablone zeichnet sich durch günstige Bildauflösung und Abriebfestigkeit aus.

## Patentansprüche

1. Polymeres der allgemeinen Formel I 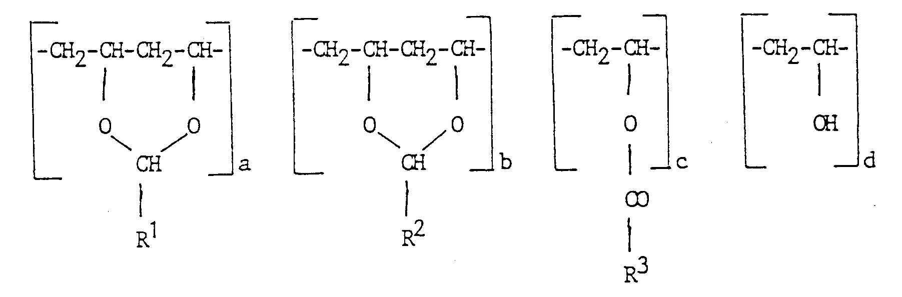 worin
R¹ einer der Reste 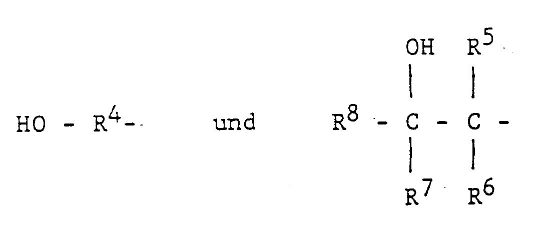
R² ein Wasserstoffatom, ein Alkylrest mit 1 bis 6 Kohlenstoffatomen, der gegebenenfalls durch Halogenatome, Aryl-, Aryloxy- oder Alkoxygruppen substituiert ist, oder ein Arylrest, der gegebenenfalls durch Halogenatome, Alkyl-, Alkoxy- oder Carbonsäureesterreste substituiert ist,
R³ ein Alkylrest mit 1 bis 4 Kohlenstoffatomen,
R⁴ eine substituierte oder unsubstituierte Alkylengruppe mit 1 bis 6 Kohlenstoffatomen ist,
R⁵ ein Wasserstoffatom, ein Alkylrest mit 1 bis 6 Kohlenstoffatomen, ein Alkoxyrest mit 1 bis 4 Kohlenstoffatomen oder ein Hydroxyalkylrest mit 1 bis 3 Kohlenstoffatomen,
R⁶ ein Rest der bei R⁵ angegebenen Bedeutung oder eine Hydroxygruppe,
R⁷ ein Wasserstoffatom oder ein Alkylrest mit 1 bis 6 Kohlenstoffatomen,
R⁸ ein Wasserstoffatom, ein Alkyl-, Hydroxyalkyl- oder Alkoxyalkylrest mit 1 bis 6 Kohlenstoffatomen oder ein substituierter oder unsubstituierter Arylrest mit 6 bis 10 Kohlenstoffatomen, 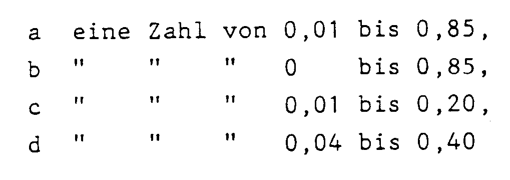 und die Summe a + b + c + d = 1 ist.

2. Polymeres gemäß Anspruch 1, dadurch gekennzeichnet, daß
R³ die Methylgruppe ist.

3. Polymeres nach Anspruch 1, dadurch gekennzeichnet, daß es ein mittleres Molekulargewicht von 5000 bis 250.000 hat.

4. Polymeres nach Anspruch 1, dadurch gekennzeichnet, daß es eine Hydroxylzahl von 150 bis 600 aufweist.

5. Lichtempfindliches Gemisch, das als wesentliche Bestandteile eine lichthärtbare Substanz und, bezogen auf das Gewicht seiner nichtflüchtigen Bestandteile, 10 bis 90 % eines Polyvinylacetals enthält, dadurch gekennzeichnet, daß das Polyvinylacetal ein Polymeres Verbindung der Formel I gemäß Anspruch 1 ist.

6. Lichtempfindliches Gemisch nach Anspruch 5, dadurch gekennzeichnet, daß die lichthärtbare Substanz ein Diazoniumsalz-Polykondensationsprodukt ist.

7. Lichtempfindliches Gemisch nach Anspruch 5, dadurch gekennzeichnet, daß die lichthärtbare Substanz ein Gemisch aus einer ethylenisch ungesättigten, radikalisch polymerisierbaren Verbindung und einem Photoinitiator für die radikalische Polymerisation ist.

8. Lichtempfindliches Gemisch nach Anspruch 5, dadurch gekennzeichnet, daß die lichthärtbare Substanz eine bei Belichtung vernetzbare oder vernetzende Verbindung ist.

9. Lichtempfindliches Aufzeichnungsmaterial mit einem Schichtträger und einer lichtempfindlichen Schicht, dadurch gekennzeichnet, daß die lichtempfindliche Schicht aus einem Gemisch gemäß Anspruch 5 besteht.

## Claims

1. A polymer of the general formula I 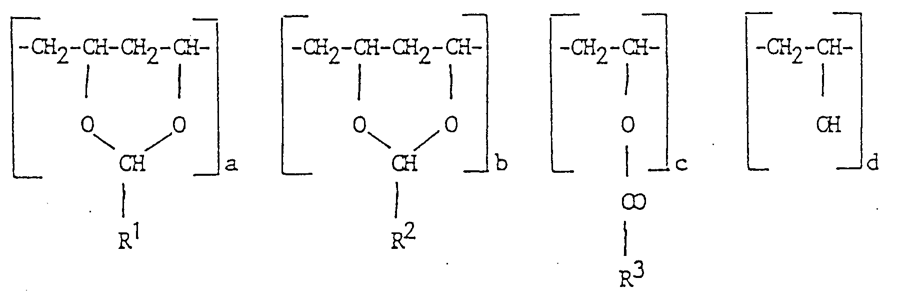 worin
R¹ einer der Reste 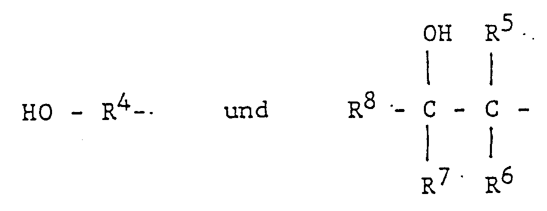
R² is a hydrogen atom, an alkyl radical containing 1 to 6 carbon atoms, which is unsubstituted or substituted by halogen atoms, aryl, aryloxy or alkoxy groups, or an aryl radical, which is unsubstituted or substituted by halogen atoms, alkyl, alkoxy or carboxylic acid ester groups,
R³ is an alkyl radical containing 1 to 4 carbon atoms,
R⁴ is a substituted or unsubstituted alkylene group containing 1 to 6 carbon atoms,
R⁵ is a hydrogen atom, an alkyl radical containing 1 to 6 carbon atoms, an alkoxy radical containing 1 to 4 carbon atoms or a hydroxyalkyl radical containing 1 to 3 carbon atoms,
R⁶ is a radical having the signification indicated for R⁵ or a hydroxyl group,
R⁷ is a hydrogen atom or an alkyl radical containing 1 to 6 carbon atoms,
R⁸ is a hydrogen atom, an alkyl, hydroxyalkyl or alkoxyalkyl radical containing 1 to 6 carbon atoms or a substituted or unsubstituted aryl radical containing 6 to 10 carbon atoms, 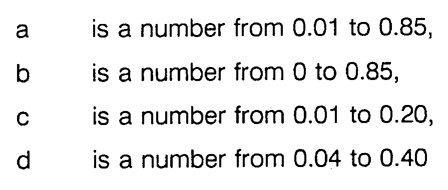
and the sum of a + b + c + d = 1.

2. A polymer as claimed in claim 1, characterized in that R³ is the methyl group.

3. A polymer as claimed in claim 1, characterized in that it has a mean molecular weight of 5,000 to 250,000.

4. A polymer as claimed in claim 1, characterized in that it has a hydroxyl number of 150 to 600.

5. Photosensitive composition which contains as the essential constituents a light-hardenable substance and, based on the weight of its non-volatile constituents, from 10 to 90 % of a polyvinyl acetal, characterized in that the polyvinyl acetal is a polymer of the formula I as claimed in claim 1.

6. A photosensitive composition as claimed in claim 5, characterized in that the light-hardenable substance is a diazonium salt polycondensation product.

7. A photosensitive composition as claimed in claim 5, characterized in that the light-hardenable substance is a mixture of an ethylenically unsaturated, radically polymerizable compound and a photoinitiator for the radical polymerization.

8. A photosensitive compositon as claimed in claim 5, characterized in that the light-hardenable substance is a compound which can be crosslinked or which crosslinks on exposure.

9. Photosensitive recording material comprising a layer support and a photosensitive layer, characterized in that the photosensitive layer is composed of a composition as claimed in claim 5.

## Revendications

1. Polymère de formule générale I 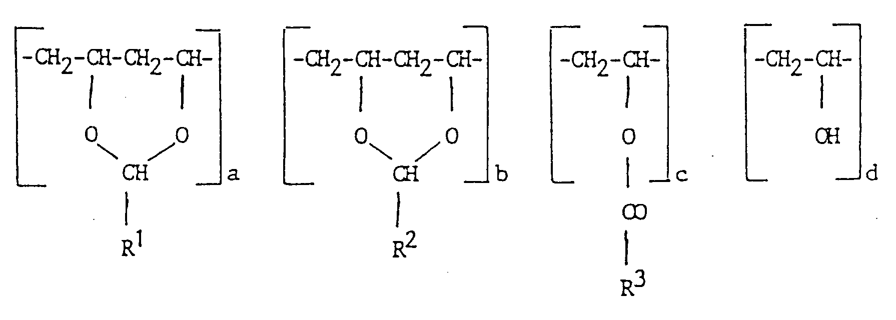 dans laquelle
R¹ est l'un des radicaux 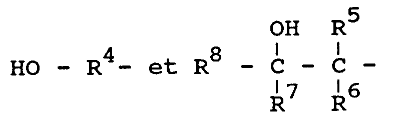
R² est un atome d'hydrogène, un radical alkyle ayant de 1 à 6 atomes de carbone, qui est éventuellement substitué par des atomes d'halogène, des groupes aryle, aryloxy ou alcoxy, ou un radical aryle qui est éventuellement substitué par des atomes d'halogène, des groupes alkyle, alcoxy ou ester d'acide carboxylique,
R³ est un radical alkyle ayant de 1 à 4 atomes de carbone,
R⁴ est un radical alkylène substitué ou non substitué, ayant de 1 à 6 atomes de carbone,
R⁵ est un atome d'hydrogène, un radical alkyle ayant de 1 à 6 atomes de carbone, un radical alcoxy ayant de 1 à 4 atomes de carbone ou un radical hydroxyalkyle ayant de 1 à 3 atomes de carbone,
R⁶ est un radical ayant la signification donnée pour R⁵ ou le groupe hydroxy,
R⁷ est un atome d'hydrogène ou un radical alkyle ayant de 1 à 6 atomes de carbone,
R⁸ est un atome d'hydrogène, un radical alkyle, hydroxyalkyle, ou alcoxyalkyle ayant de 1 à 6 atomes de carbone ou un radical aryle substitué ou non substitué ayant de 6 à 10 atomes de carbone, 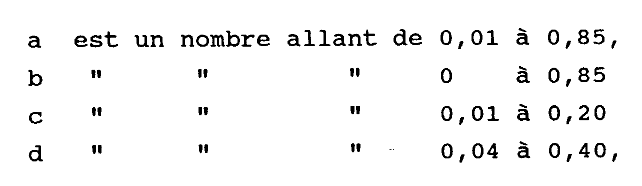
et la somme a + b + c + d = 1.

2. Polymère selon la revendication 1, caractérisé en ce que R³ est le groupe méthyle.

3. Polymère selon la revendication 1, caractérisé en ce qu'il a une masse moléculaire moyenne de 5 000 à 250 000.

4. Polymère selon la revendication 1, caractérisé en ce qu'il présente un indice d'hydroxyle de 150 à 600.

5. Composition photosensible contenant, en tant que composants essentiels, une substance photodurcissable et, par rapport au poids de ses composants non volatils, de 10 à 90 % d'un poly(acétal de vinyle), caractérisée en ce que le poly(acétal de vinyle) est un composé polymère de formule I selon la revendication 1.

6. Composition photosensible selon la revendication 5, caractérisée en ce que la substance photodurcissable est un produit de polycondensation de sel de diazonium.

7. Composition photosensible selon la revendication 5, caractérisée en ce que la substance photodurcissable est un mélange d'un composé à insaturation éthylénique, polymérisable par polymérisation radicalaire, et d'un photoinitiateur pour la polymérisation radicalaire.

8. Composition photosensible selon la revendication 5, caractérisée en ce que la substance photodurcissable est un composé se réticulant ou réticulable à l'insolation.

9. Matériau de reprographie photosensible comportant un support de couche et une couche photosensible, caractérisé en ce que la couche photosensible est constituée d'une composition selon la revendication 5.
